# EUROPÄISCHE PATENTANMELDUNG

(11) **EP 2 197 075 A1**
(43) Veröffentlichungstag der Anmeldung: **16.06.2010**
(21) Anmeldenummer: 09174617.2
(22) Anmeldetag: 30.10.2009
(51) Int. Cl.: H01R 11/28

(54) **Polklemmenanordnung**

(30) Priorität: 10.12.2008 DE 102008054452
(71) Anmelder: Robert Bosch GmbH, 70442 Stuttgart (DE)
(72) Erfinder: Mazingue-Desailly, Stephan, 71640, Ludwigsburg (DE); Utz, Udo, 71254, Ditzingen (DE); Ben Salah, Amin, 74321, Bietigheim-Bissingen (DE); Feufel, Regina, 71706, Markgroeningen (DE); Mueller, Michael, 71277, Rutesheim (DE)

(57) **Zusammenfassung**

Es wird eine Polklemmenanordnung für eine Batterie (5) mit einer elektronischen Schaltung und mit einem Shuntwiderstand zur Auswertung mindestens von Stromgrößen des an die Polklemme (2) anschließbaren Laststromkreises vorgeschlagen. Die Polklemmenanordnung (1) weist ein elektrisch leitendes Metallteil (3) auf, das einstückig mit der Polklemme (2) an einen Pol (4) der Batterie (5) anfügbar ist und derart abgewinkelt aus einer Nische (7) der Batterie (5) weitergeführt ist, dass es außerhalb der Batterieoberfläche zu liegen kommt und dort im Verlauf zu einer Anschlussklemme (6) für den Laststromkreis mit der elektronischen Schaltung und einem integrierten Shuntwiderstand versehen ist.

## Beschreibung

### Stand der Technik

Die Erfindung betrifft eine Polklemmenanordnung, beispielsweise für den Anschluss eines Laststromkreises an eine Kraftfahrzeugbatterie, mit einer elektronischen Schaltung, die einen integrierten Shuntwiderstand aufweist, mittels dem die Stromgrößen auswertbar sind, insbesondere für die Zustandserkennung der Batterie als Bestandteil eines Energiemanagementsystems in Kraftfahrzeugen, nach der Gattung des Hauptanspruchs.

Eine steigende Anzahl elektrischer Verbraucher in Kraftfahrzeugen erfordert, insbesondere um Feldausfälle (sog. Liegenbleiber) aufgrund zu stark entladener oder defekter Batterien zu vermeiden, zunehmend den Einsatz des eingangs erwähnten Energiemanagementsystems in Verbindung mit einer zuverlässigen intelligenten Batteriezustandserkennung (Batteriesensor), die teilweise oder vollständig die benötigten Batterieinformationen aus den messbaren Batteriegrößen Strom, Spannung und Temperatur mit hoher Genauigkeit und hoher Abtastrate erfasst. Das elektrische Energiemanagement befindet sich dabei in der Regel in einem sogenannten Host-Steuergerät (z. B. Body Computer, Gateway, Motor-Steuergerät, etc.), das mit dem Batteriesensor über eine einfache und kostengünstige serielle Schnittstelle, vorzugsweise ein sogenannter LIN-Bus, kommuniziert.

Aus der US 6628102 B2 ist es beispielsweise bekannt, dass ein solcher Batteriesensor mit einer elektronischen Schaltung und einem Shuntwiderstand in den Deckel einer Batterie integriert ist. Beide Polklemmen werden dazu über den Deckel der Batterie mit zwischengeschalteten Shuntwiderständen verlängert hinausgeführt und der Batteriesensor ist dann zwischen diesen Polklemme angeordnet.

Um einfache und kostengünstige Batteriesensoren, insbesondere für die zunehmend erforderlichen Energiemanagementsysteme, für eine Vielzahl von Anwendungen nicht nur bei größeren Kraftfahrzeugen sondern auch bei vielen Varianten von Mittel- und Kleinfahrzeugen zu realisieren, bei denen oft auch Platznot im Motorraum herrscht, sind starre und aufwendige Konzepte nachteilig.

### Offenbarung der Erfindung

Die Erfindung geht von einer Polklemmenanordnung für eine Batterie mit einer elektronischen Schaltung und mit einem Shuntwiderstand zur Auswertung mindestens von Stromgrößen des an die Polklemme anschließbaren Laststromkreises aus. Erfindungsgemäß weist die Polklemmenanordnung ein elektrisch leitendes Metallteil als Polklemme auf, das an einen Pol der Batterie anfügbar ist und in vorteilhafter Weise derart abgewinkelt weitergeführt ist, dass es außerhalb der Batterieoberfläche zu liegen kommt und dort im Verlauf zu einer Anschlussklemme für den Laststromkreis mit der elektronischen Schaltung und einem integrierten Shuntwiderstand versehen ist.

Der Pol der Batterie ist hier vorzugsweise der negative Pol, wobei die Batterie gemäß einer besonders vorteilhaften Ausführungsform in einem Kraftfahrzeug untergebracht ist und die elektronische Schaltung ist über Datenleitungen mit einem Energiemanagement-system im Kraftfahrzeug verbunden.

Die elektronische Schaltung kann dabei auf einfache Weise mit dem integrierten Shuntwiderstand in einem Gehäuse untergebracht werden, das an das Metallteil eng angefügt ist, zum Beispiel durch Vergießen.

Das Gehäuse der erfindungsgemäßen Polklemmenanordnung kann dabei oberhalb des Deckels der Batterie oder auch seitlich neben der Batterie zu liegen kommen.

Mit der Erfindung kann somit aufgrund der zunehmenden Verbreitung der eingangs erwähnten Energiemanagementsysteme in Kraftfahrzeugen eine besonders flexible Lösung beim Anschluss der Polklemmen und dem Anbringen der elektronischen Schaltung und der Shuntwiderstände des Batteriesensors realisiert werden, um verschiedenste Fahrzeugvarianten mit einem einfachen Mechanikkonzept ausrüsten zu können. Die beschriebene Erfindung ist dabei nicht ausschließlich auf den Einsatz mit den erwähnten Batteriemanagementsystemen beschränkt, sondern sie kann überall dort angewendet werden, wo aufgrund von Platznot insbesondere im Motorraum des Kraftfahrzeugs eine platzsparende Anbringung von Anschlüssen des Laststromkreises vorteilhaft ist.

### Kurze Beschreibung der Zeichnung

Die Erfindung wird nachfolgend anhand des in der Figur der Zeichnung gezeigten Ausführungsbeispiels erläutert. Dabei zeigt:

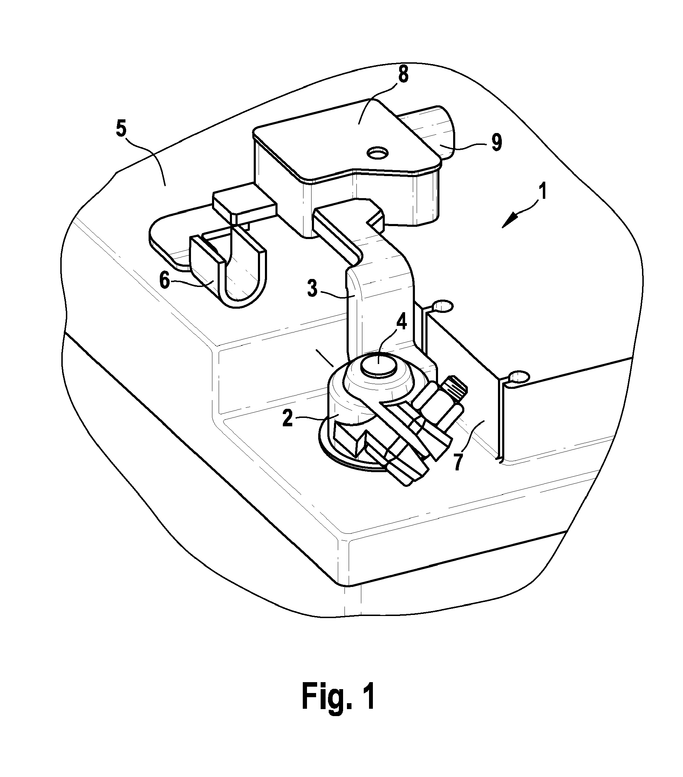

Figur 1 eine Darstellung einer Polklemmenanordnung mit einer Polklemme an einer Batterie für ein Kraftfahrzeug mit einem erfindungsgemäß abgewinkelten Metallteil.

### Ausführungsform der Erfindung

In Figur 1 ist eine Polklemmenanordnung 1 gezeigt, die eine Polklemme 2 als Bestandteil eines elektrisch leitenden Metallteils 3 für den Anschluss eines Pols 4, hier der negative Pol, einer hier nur angedeuteten Batterie 5 an einen Laststromkreis eines Kraftfahrzeugs mittels einer Anschlussklemme 6 aufweist.

Das Metallteil 3 ist dabei derart abgewinkelt aus einer Nische 7 der Batterie 5 herausgeführt, dass es hier oberhalb des Deckels der Batterie 5 zu liegen kommt. In diesem Bereich ist hier ein Gehäuse 8 mit einer elektronischen Schaltung und einem Shuntwiderstand angeordnet. Die elektronische Schaltung im Gehäuse 7 kann über Datenleitungen 9 mit einem Energiemanagement-System im Kraftfahrzeug verbunden werden.

## Patentansprüche

1. Polklemmenanordnung für eine Batterie (5) mit einer elektronischen Schaltung und mit einem Shuntwiderstand zur Auswertung mindestens von Stromgrößen des an die Polklemme (2) anschließbaren Laststromkreises, **dadurch gekennzeichnet, dass** die Polklemmenanordnung (1) ein elektrisch leitendes Metallteil (3) aufweist, das einstückig mit der Polklemme (2) an einen Pol (4) der Batterie (5) anfügbar ist und derart abgewinkelt aus einer Nische (7) der Batterie (5) weitergeführt ist, dass es außerhalb der Batterieoberfläche zu liegen kommt und dort im Verlauf zu einer Anschlussklemme (6) für den Laststromkreis mit der elektronischen Schaltung und einem integrierten Shuntwiderstand versehen ist.

2. Polklemmenanordnung nach Anspruch 1, **dadurch gekennzeichnet, dass** der Pol (4) der Batterie (5) der negative Pol ist.

3. Polklemmenanordnung nach Anspruch 1 oder 2, **dadurch gekennzeichnet, dass** die elektronische Schaltung mit dem integrierten Shuntwiderstand in einem Gehäuse (8) untergebracht ist, das an das Metallteil (3) eng angefügt ist.

4. Polklemmenanordnung nach Anspruch 3, **dadurch gekennzeichnet, dass** das Gehäuse (8) oberhalb des Deckels der Batterie (5) zu liegen kommt.

5. Polklemmenanordnung nach Anspruch 3, **dadurch gekennzeichnet, dass** das Gehäuse (8) seitlich neben der Batterie (5) zu liegen kommt.

6. Polklemmenanordnung nach einem der vorhergehenden Ansprüche, **dadurch gekennzeichnet, dass** die Batterie (5) in einem Kraftfahrzeug untergebracht ist und die elektronische Schaltung über Datenleitungen (9) mit einem Energiemanagement-System im Kraftfahrzeug verbunden ist.
